# EUROPÄISCHE PATENTSCHRIFT

(11) **EP 1 101 122 B1**
(45) Veröffentlichungstag und Bekanntmachung des Hinweises auf die Patenterteilung: **06.03.2002**
(21) Anmeldenummer: 99941428.7
(22) Anmeldetag: 15.07.1999
(51) Int. Cl.: G01R 27/26, G01R 27/00

(54) **QUASI-HEMISPHÄRISCHER FABRY-PEROT-RESONATOR UND VERFAHREN ZUM BETREIBEN DESSELBEN**
QUASI-HEMISPHERICAL FABRY-PEROT RESONATOR AND METHOD FOR OPERATING THE SAME
RESONATEUR DE FABRY-PEROT QUASI HEMISPHERIQUE ET SON MODE D'UTILISATION

(30) Priorität: 01.08.1998 DE 19834854
(43) Veröffentlichungstag der Anmeldung: 23.05.2001
(73) Patentinhaber: Forschungszentrum Karlsruhe GmbH, 76133 Karlsruhe (DE)
(72) Erfinder: HEIDINGER, Roland, D-76227 Karlsruhe (DE); SCHWAB, Reiner, D-76131 Karlsruhe (DE); BURBACH, Jakob, D-76344 Eggenstein-Leopoldshafen (DE); HALBRITTER, Jürgen, D-76646 Bruchsal (DE)
(86) Internationale Anmeldenummer: EP9905019
(87) Internationale Veröffentlichungsnummer: WO0008477

(56) Entgegenhaltungen:
- US-A- 5 239 269
- KOMIYAMA B ET AL: "MILLIMETER WAVE SURFACE RESISTANCE MEASUREMENTS OF HIGH-TC SUPERCONDUCTIVE THIN FILMS USING A NB OPEN RESONATOR" EUROPEAN MICROWAVE CONFERENCE PROCEEDINGS,GB,NEXUS BUSINESS COMMUNICATIONS, Bd. CONF. 24, 5. September 1994 (1994-09-05), Seite 986-991 XP000678184 ISBN: 0-9518-0325-5
- KOMIYAMA ET AL.: "OPEN RESONATOR FOR PRECISION DIELECTRIC MES SUREMENTS IN THE 100 GHZ BAND" IEEE TRANS. ON MICROWAVE THEORY AND TECHNIQUES, Bd. 39, Nr. 10, Oktober 1991 (1991-10), Seiten 1792-1796, XP002122812
- PATENT ABSTRACTS OF JAPAN vol. 1997, no. 11, 28. November 1997 (1997-11-28) & JP 09 199297 A (TOSHIBA), 31. Juli 1997 (1997-07-31)
- HIRVONEN T M ET AL: "MEASUREMENT OF DIELECTRICS AT 100 GHZ WITH AN OPEN RESONATOR CONNECTED TO A NETWORK ANALYZER" IEEE TRANSACTIONS ON INSTRUMENTATION AND MEASUREMENT,US,IEEE INC. NEW YORK, Bd. 45, Nr. 4, 1. August 1996 (1996-08-01), Seite 780-786 XP000623065 ISSN: 0018-9456

## Beschreibung

Die Erfindung betrifft einen quasi-hemisphärisches Fabry-Perot-Resonator zur Bestimmung des Oberflächenwiderstands eines Dünnschichtmaterials im mm-Wellenbereich.

Für die Herstellung nachrichtentechnischer Komponenten (z. B. Filter, Oszillatoren) werden gut leitende Dünnschichtmaterialien, in besonderer Weise auch aus Hochtemperatursupraleitern (z. B. YBCO), strukturiert. Die Dünnschichtmaterialien werden als Filme auf großflächige Substrate (Wafer) über Sputter- oder Bedampfungsprozesse erzeugt. Zur Zertifizierung einer geeigneten Filmherstellung werden zerstörungsfrei bestimmte Materialparameter (u. a. Sprungtemperatur T_{c}, kritische Stromdichten j_{c}) herangezogen, wobei der Oberflächenwiderstand Rₛ den größten Anwendungsbezug hat. Durch ortsaufgelöste Rasterung, die diesen Parameter über die interessierende Waferfläche quantitativ bestimmt, wird die Reproduzierbarkeit und die Homogenität der supraleitenden Filmeigenschaften nachgewiesen.

Über den Einsatz von Fabry-Perot-Resonatoren zur temperaturvariablen Bestimmung von Rₛ bei tiefen Temperaturen wurde unter der Verwendung von supraleitenden Spiegelmaterialien (Niob) schon von Komiyama et al. (in Appl. Phys. Lett. 68(4), 22 January 1996, p 562 - 563 unter dem Titel "Penetration depth measurements ...") und in der WUB-DIS 94-9 von S. Orbach-Werbig unter dem Titel "Oberflächenimpedanz epitaktisch aufgewachsener YBa₂Cu₃O_{7-δ}-Filme bei 87 GHz" berichtet. Während die erste Arbeit über keine Vorkehrung für ortsaufgelöste Messungen berichtet, wurde in der zweiten eine Verstellung über ein handgeführtes Getriebe zur Rotation der Probe eingerichtet. Ortsaufgelöste Rₛ-Bestimmungen bei fester Temperatur (77 K) werden durchgeführt unter Verwendung von normalleitenden Spiegelmaterialien (Aluminium): Martens et al. (US 5,239,269).

Aus den Kongressunterlagen der MIOP 97 ist von R. Heidinger und R. Schwab ein quasi hemisphärischer Fabry-Perot-Resonator zur Bestimmung des Oberflächenwiderstands im Millimeterwellen-Bereich bekannt. Änderungen der DC-Leitfähigkeit in den Spiegelmaterialien und daraus resultierende Änderungen von Rₛ wurden über einen weiten Temperaturbereich von 20 - 340 K und für verschiedene Materialkonfigurationen (Cu, Ag, Messing) über Gütemessungen integral über den gesamten Prüfling hinweg, also nicht ortsaufgelöst, erfaßt. In einem zweiten Resonator mit einer speziell fokussierten Spiegelkonfiguration, der nur bei Raumtemperatur betrieben werden kann, wird die Registrierung lokaler Rₛ -Inhomogenitäten anhand von Demonstrationsspiegeln mit einer scharfen Widerstandsstufe demonstriert. Es handelt sich dabei um ein Freiraumexperiment also keine abgeschlossene Umgebung.

Die bisher bekannten Lösungsansätze lassen nicht bzw. nur unbefriedigend die kombinierte ortsaufgelöste und temperaturvariable quantitative Bestimmung der Rₛ-Werte zu. In den beschriebenen Systemen, die auf supraleitendem Niob beruhen, gelingt es nicht die Koppelgeometrie so einzurichten, daß Streuverluste an den Koppellöchern gering gehalten werden. Dies liegt inhärent an der im Vergleich zu dem bei der Erfindung eingesetztem Kupfer schweren Bearbeitbarkeit von Niob und speziell auch an der notwendigen hochfrequenztechnischen Prüfung der Geometrie unterhalb der Sprungtemperatur von Niob (9,4 K), die keine direkten Korrekturmaßnahmen erlaubt. Mit diesen Experimenten wurden bisher noch keine Absolutwerte des örtlichen Oberflächenwiderstandes Rₛ bestimmt.

Ansätze der ortsaufgelösten Vermessung scheitern an einer verläßlichen systematischen Rasterung, an der Schwergängigkeit und mangelnden Positioniergenauigkeit der handgetriebenen Gestängeführung (Orbach (1994)). Die ortsaufgelöste Messung mit (quasi)-konfokalen Fabry-Perot-Resonatoren besitzen nicht die nötige Stabiltät der Temperaturumgebung, weil sie nicht mit einer entsprechenden Kryoumgebung ausgestattet sind, um T-variable Messungen durchzuführen.

Der Erfindung liegt die Aufgabe zugrunde, durch die Identifaktion von Bereichen mit erhöhten Oberflächenwiderstandswerten, die auf erhöhte, von außen einwirkende Beiträge zurückzuführen sind, ungeeignete Filmbereiche auszugrenzen. Gezielte Vergleichsmessungen der Temperaturabhängigkeit von Rₛ über die Oberfläche sollen die geeignete Datenbasis zur Quantifizierung der Größe der von außen eingetragenen Einflüsse auf die Materialqualität und der lokalen Sprungtemperatur für die systematische Korrelation mit den Sputter- oder Aufdampfprozeßparametern bereitstellen.

Die Aufgabe wird durch einen quasi-hemisphärischen Fabry-Perot-Resonator (FPR) nach dem Oberbegriff des Anspruchs 1 und seinen kennzeichnenden Merkmalen und durch ein Verfahren gemäß den Verfahrensschritten des Anspruch 6 gelöst.

Das Neue der Erfindung liegt in der Kombination einer hochentwickelten Meßtechnik zur hochaufgelösten quantitativen Bestimmen von Rₛ mittels eines (quasi)-hermisphärischen Resonatoraufbaus mit Kupferspiegeln und einem geeigneten Verdampferkryostatensystem, das unter Verwendung zweier Strahlungsschilde und einer geeigneten Plazierung der rechnergesteuerten Stellelemente, die reproduzierbare Orts- und Temperaturvariation der supraleitenden Dünnschichtprobe im Millimeterwellenstrahl zuläßt.

Das innere Strahlungsschild ist vollständig von dem äußeren umgeben. Beide bestehen aus einer kühlmitteldurchströmten Basisplatte mit der aufgesetzten verspiegelten Haube. Beide Basisplatten sind, von der Kühlmittelströmung her gesehen, hintereinandergeschaltet, wobei die des inneren Strahlungsschildes zu Beginn der Kühlmittelzufuhr liegt und über nicht oder allenfalls schlecht wärmeleitende Füße mechanisch stabil auf der äußeren aufsitzt.

Auf der Basisplatte des inneren Strahlungsschildes ist der quasi-hemisphärische Resonator mit gutem Wärmeleitungskontakt aufgestellt. Der sphärische Spiegel ist fest und gut wärmegekoppelt auf die Basisplatte montiert. Über mindestens zwei Heizelemente auf dieser Basisplatte symmetrisch zur projezierten Resonatorachseder liegen Heizelemente, deren Wärmeeintrag über Temperatursensoren auf dem Wärmeleitungsweg zum sphärischen Spiegel überwacht und gesteuert wird. Der plane Spiegel sitzt an dem verfahrbaren, schlecht wärmeleitenden Auslegerarm und ist daher zum Einhalten des definierten Kryosystems mit der Basisplatte über ein flexibles gut wärmeleitendes (Metall-) Band verbunden, um die Verfahrensfreiheit, insbesondere die Rotation bis zu 360° des Spiegels um die Resonatorachse zuzulassen. Darüber hinaus ist er über ein angebautes Heizelement separat erwärmbar, wobei die Temperatur des ebenen Spiegels über einen Temperatursensor in der Nähe überwacht und gesteuert wird. Die Heizelemente dienen dazu, einen definierten Wärmeeintrag einzubringen, um thermisches Gleichgewicht zwischen den Spiegeln auch beim Aufwärmen zu erhalten.

Das zweite Strahlungsschild steht ebenfalls wärmeentkoppelt auf der Montageplatte, auf der der Resonator indirekt und der Auslegerarm unmittelbar mit seiner Basis montiert ist.

Die beiden Strahlungsschilde haben aufgrund des durchreichenden, schlecht wärmeleitenden Auslegerarms je einen Ausschnitt, damit sie bei notwendigen Manipulationen (z. B. Probenwechsel) im Resonatorraum abgenommen werden können. Um die Strahlungsschilde während der Vermessung strahlungsmäßig stets geschlossen zu halten, besteht im Bereich des Auslegerarms eine bereichsweise überlappende Doppelwand, wobei beide Teilwände auf ihrem zugehörigen Dreharm sitzen, der für das innere Strahlungsschild auf der inneren Basisplatte im Mittelpunkt drehbar gelagert ist und für das äußere Strahlungsschild entsprechend auf der unteren. Beim seitlichen Verfahren des Auslegerarms werden beide Teilwände unter einer Kreisbewegung mitgenommen.

Kryogene Anlagen werden häufig derartig ausgelegt, daß die Kühlleistung so klein wie möglich gehalten werden kann, d. h. die Wärmekapazität oder die Massen im Kryobereich so klein wie möglich zu halten. Hier besteht eine andere, entgegengesetzte Notwendigkeit aufgrund der thermisch bedingten Verstimmung des Resonators während der Auslesezeit einer Resonanz, diese Verstimmung soll zumindest vernachlässigbar bleiben, dem entsprechend haben beide Spiegel eine Mindestmasse oder äquivalent eine notwendig große Wärmekapazität.

In den Unteransprüchen 2 bis 5 sind vorteilhafte Ausgestaltungen des Resonators gekennzeichnet, die ein störungsfreies Handhaben und einen störungsfreien Verfahrensablauf der Vermessung ermöglichen.

Da für gute Wärmekopplung des ebenen Spiegels mit der inneren Basisplatte ein flexibles, für die Volldrehung des Spiegels entsprechend langes Wärmeleitungsband notwendig ist, muß eine Einrichtung am Spiegel angebracht werden, die verhindert, daß bei irgend einer Drehposition das Band in den Resonatorbereich fallen kann. Hierzu ist der Spiegel mit einem trichterförmigen Kragen umgeben, der das verhindert (Anspruch 2).

Die Wärmeentkopplung zwischen den beiden Basisplatten wird vorteilhaft mit Glasfaserbolzen realisiert, ebenso die Entkopplung zwischen der äußeren Basisplatte und der Montageplatte. Andere Materialien, die die Wärmeleitung hinreichend unterbinden und für das System geeignet sind, können natürlich ebenso verwendet werden (Anspruch 3). Die Auflage hat darüber hinaus auch den Sinn, das Einbringen von mechanischen Biegemomenten auf die Platten zu unterbinden. Das betrifft insbesonder die Auflage der Montageplatte auf der Basisplatte der alles umschließenden Vakuumkammer.

Konstruktiv am einfachsten bleiben die beiden Strahlungsschilde, wenn Verstellungen am Resonator während des Vermessens sich auf den Auslegerarm beschränken, deshalb sind alle Stellelemente am Auslegerarm außerhalb der beiden Strahlungsschilde (Anspruch 4). Des weiteren werden sie außerhalb der Strahlungsschilde gehalten, um keinen parasitären Temperatureintrag im Resonatorraum einzuleiten. Für die Funktion der Stellelemente ist andrerseits wichtig, daß sie sich in einer Umgebung mit Raumtemperatur befinden, nur dann können sie betrieben werden.

Der gekennzeichnete Resonator ermöglicht erst das Verfahren gemäß Anspruch 6 zur zerstörungsfreien und kontaktlosen Bestimmung des ortsaufgelösten und temperaturabhängigen Oberflächenwiderstands Rₛ von elektrisch leitenden Dünnschichtmaterialien.

Beide hoch oberflächenvergütete Spiegel sind aufeinander ausgerichet, wobei der ebene an dem mit drei Freiheitsgraden beweglichen Auslegerarm montiert ist. Somit kann jede Stelle der exponierten Oberfläche der am ebenen Spiegel aufgebrachten Dünnschicht in den Fokusfleck der von der Auskoppelöffnung des sphärischen Spiegels emittierten Mikrowelle feinstufig gefahren werden.

Über die beiden Strahlungsschilde werden definierte kryogene Umgebungen eingestellt, die zulassen, den Temperatureinfluß zu quantifizieren.

Der Ablauf des Meßverfahrens erfolgt rechnergesteuert, um in erträglichen, insbesondere wirtschaftlich erträglichen Zeiträumen die Aussage über eine vermessene Dünnschicht treffen zu können.

Die am Prüfling reflektierte Mikrowelle wird über ein empfindliches Detektorsystem erfaßt, dessen Eingang die Auskoppelöffnung im sphärischen Spiegel unmittelbar neben der Einkoppelöffnung ist. Es wird die Transmission der Mikrowelle als Funktion der Frequenz erfaßt und im Rechner mittels der Anpassung nach der Methode der kleinsten Fehlerquadrate gemäß einer Lorentzverteilung parametrisiert. Daraus wird der Gütewert gewonnen, der um die Beiträge der Reflektionsverluste am sphärischen Spiegel (Oberflächenwiderstand R_{Sph}) und der Streuverluste durch das Ein- und Auskoppelloch korrigiert wird. Schließlich wird der orts- und temperaturabhängige Wert des Oberflächenwiderstands daraus bestimmt.

Die über vollständig rechnergestützte Meßprozeßführung zu erzielenden, dichtliegenden orts- und temperaturvariablen Meßpunkte erlauben erstmals eine quantitative Qualifizierung der unterschiedlichen Filmbereiche in Form einer modellgestützten Anpassung und einer Sprungtemperaturbestimmung. Damit wird für die Zertifizierung und die gezielte Verbesserung der Filmherstellung die einsatzrelevante Datenbasis erzeugt.

Die Erfindung wird im folgenden anhand der Zeichnungen näher erläutert. Es zeigen:

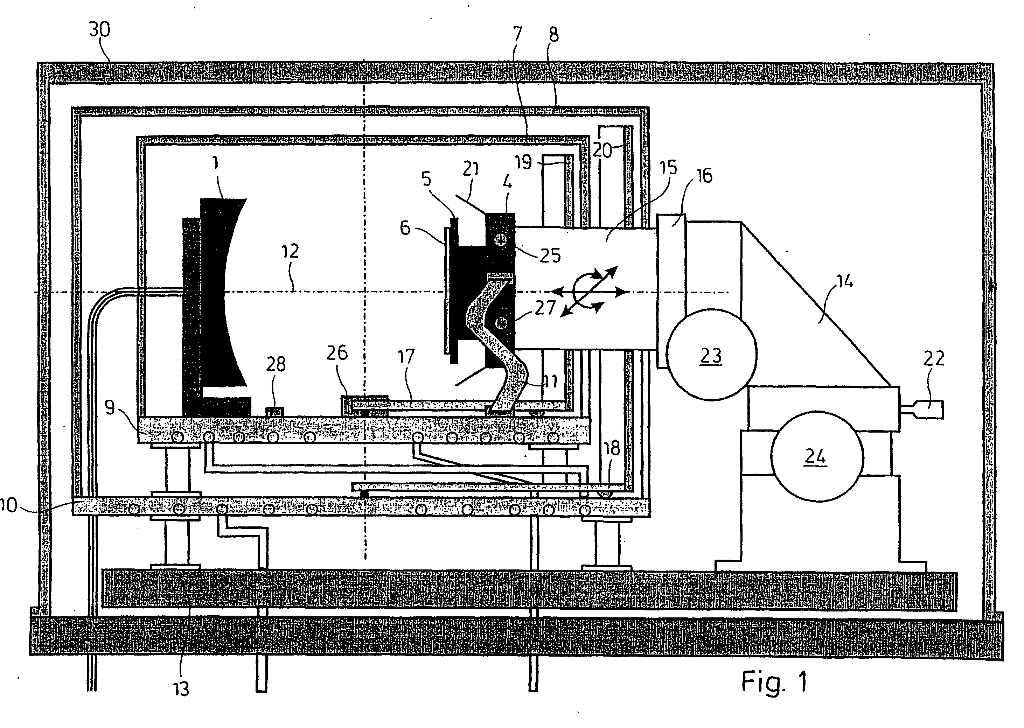

Fig. 1 den Schnitt durch den gesamten schematischen Aufbau des quasi hemisphärischen Fabry-Perot-Resonators ,
Fig. 2 den Resonator alleine,
Fig. 3a einen Kupfer-Messing-Spiegel als Demonstrationsobjekt für die Bestimmung des ortsabhängigen Oberflächenwiderstands,
Fig. 3b der zugehörige Q-Faktor in Abhängigkeit der radialen Position,
Fig. 4a die Verteilung des örtlichen Oberflächenwiderstand auf einer YBCO-Dünnschichtfläche,
Fig. 4b der Verlauf des örtlichen Widerstands an ausgewähltem Ort in Abhängigkeit der Temperatur.

Die zerstörungsfreie und kontaktierungslose Bestimmung von Rₛ geht über die Analyse der Gauß'schen Grundmoden in einem (quasi)-hemisphärischen Fabry-Perot-Resonator. Dieser Resonator besteht aus dem sphärischen und dem ebenen Kupferspiegel 1,4 hoher Oberflächengüte und elektrischer Leitfähigkeit, die beide einen Abstand derart voneinander haben, daß der Spiegelabstand 1 geringfügig kleiner oder höchstens gleich dem Spiegelradius r ist.

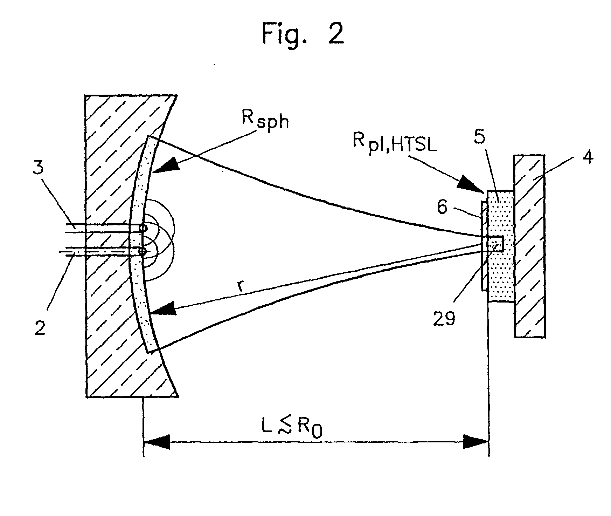

In den sphärischen Spiegel 1 sind über Elektroerosion die zwei hochfrequenztechnisch ausgelegte Koppellöcher 2,3 durcherodiert (siehe Figur 2), die zur Ein- bzw. Auskopplung des Millimeterwellensignals (f = 144 - 146 Ghz) dienen.

Auf den ebenen Spiegel 4 ist der Wafer 5 mit dem aufgebrachten Dünnschichtmaterial 6 über Klemmen aufgebracht, um der Mikrowelle ausgesetzt werden zu können. Die Transmission durch den Resonator also Reflexion an der Dünnschichtoberfläche 6 wird als Funktion der Frequenz über ein empfindliches Detektorsystem leistungsgemäß erfaßt, dessen Eingang die Auskoppelöffnung 3 am sphärischen Spiegel 1 ist (siehe Figur 2). Das Einkoppelloch 2 liegt hier auf der Resonatorachse 12, das Auskoppelloch 3 unmittelbar daneben. Wichtig ist nur, daß sie aus strahloptischen Gründen in der Nähe der Resonatorachse 12 und nahe beieinander liegen.

Von wesentlicher Bedeutung ist das Erreichen einer einheitlichen kryogenen Umgebung um den Resonatoraufbau, damit Temperaturschwankungen, die zu einer Resonanzlinienverbreiterung und damit zu einer Verfälschung des aufgenommenen Gütewertes führen, ausgeschlossen werden. Dies wird durch das zweifache Strahlungsschild 7, 8 erreicht, wovon das innere 7 auf Kühlflächentemperatur und das äußere auf Abgastemperatur liegt, weil die Durchströmung durch die Kanäle der Basisplatten 9, 10 seriell erfolgt und die obere Basisplatte 9 zuerst angeströmt wird.

Durch geringen Temperatureintrag, der durch rechnergeführte Heizleistung an Heizelementen 25, 26 auf der Basisplatte 9 und am Planspiegel 4 erzeugt wird, kann das Meßsystem in seiner Temperatur oberhalb der erreichten Tiefsttemperatur (10 K bei flüssigem Helium als Kühlmittel, 75 K bei Stickstoff als Kühlmittel) variiert werden.

Die reproduzierbare Verschiebung der Probe 6 im Millimeterwellenfeld wird über die Stellelemente 23, 24 am Auslegerarm 14 vorgenommen, die alle außerhalb der beiden Strahlungsschilde 7, 8 aber innerhalb der Vakuumkammer 30 liegen. Zur zuverlässigen und feinen Verstellung sind sie 23, 24 rechnergeführt, so daß mechanische Vakuumdurchführungen entfallen.

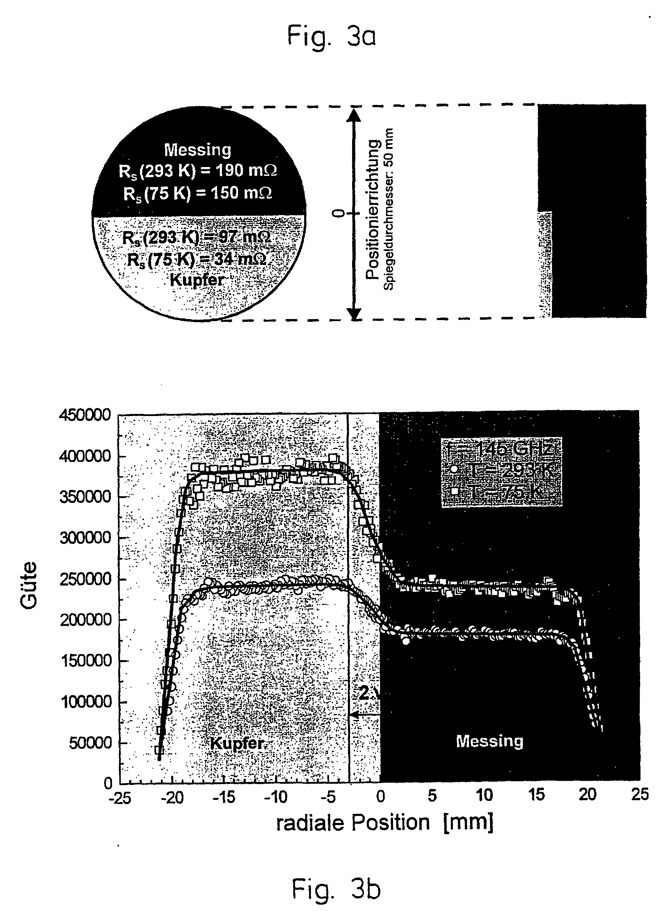

Zur Demonstration der grundsätzlichen Leistungsfähigkeit des Resonators und des Verfahrens, mit dem er betrieben wird, besteht die exponierte Oberfläche des ebenen Spiegels 4 aus dem kreisscheibenförmigen Meßobjekt 6 von 50 mm Durchmesser mit einer Halbkreisfläche aus Kupfer und der anderen aus Messing und hat damit eine scharfe Stufe des Oberflächenwiderstands Rₛ. Der Fokusfleck 29 der Mikrowelle von 145 GHz bewegt sich zur Messung senkrecht zu der Trennlinie über die Oberfläche hinweg (Figur 3a).

In Figur 3b ist die gemessene Resonatorgüte Q über der radialen Position auf dem Kupfer-Messing-Spiegel 6 (Figur 3a) einmal bei Raumtemperatur (T = 293 K, obere Kurve) und zum andern bei T = 75 K (untere Kurve) aufgetragen. Es wird über den gesamten Durchmesser des Kupfer-Messing-Spiegels 6 abgetastet. Dabei wird die Rₛ-Stufe als kontinuierlicher Übergang von dem Wert von Messing- Rₛ = 190 mΩ bei T = 293 K und Rₛ = 150 mΩ bei T = 75 K - auf den Wert von Kupfer - Rₛ = 97 mΩ bei T = 293 K und Rₛ = 34 mΩ bei T = 75 K - über eine Strecke von 2wₒ = 6,5 mm festgestellt. Die Güten innerhalb des Kupfer- und Messing-Bereichs sind konstant, zeigen jedoch deutlich unterschiedliche Temperaturabhängigkeit. Der stetige, nicht sprunghafte Übergang von Messing auf Kupfer entspricht dem berechneten Fokusfleck 2wₒ des Strahls im Resonator und bildet somit eine obere Schranke für die Ortsauflösung des Systems. Der scharfe Abfall der Güte am Rand des Spiegels kommt durch die Beugungsverluste am Rande zustand, die einsetzen, sobald der Strahl beginnt den Spiegelrand zu überlappen.

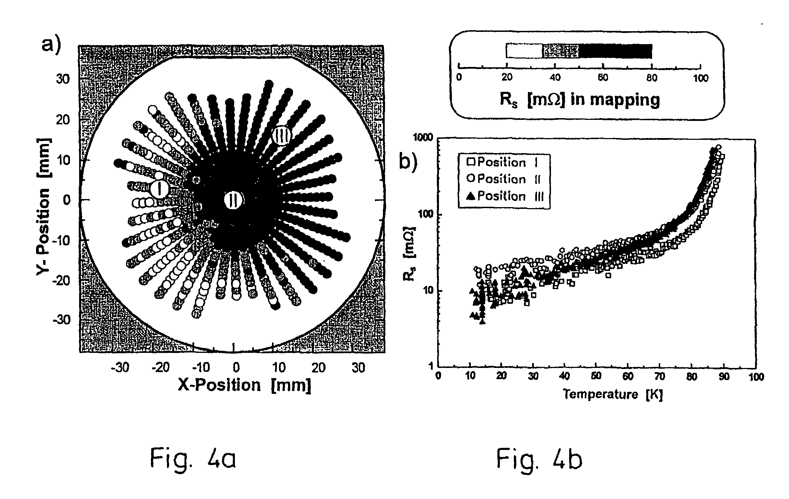

Die Leistungsfähigkeit wird weiter an der Vermessung des Hochtemperatursupraleiters YBa₂Cu₃O₇ untermauert. Die YBCO-Schicht (400 nm) ist auf einem Substrat 5 aufgebracht und hat einen Durchmesser von 3 Zoll. Figur 4a zeigt die Rₛ-Kartierung der Supraleiteroberfläche bei der Temperatur von 77 K also unterhalb de Sprungtemperatur T_{c}. Die Rₛ-Werte sind als Graustufen über der Fläche eingetragen und es treten deutlich flächige Inhomogenitäten von Rₛ auf (Figur 4a).

An den Positionen 1, 2 und 3 wurden zur Klassifizierung der beobachteten Inhomogenitäten weitere temperaturvariable Messungen durchgeführt. Die Rₛ-Werte an diesen Positionen sind in Figur 4b in Abhängigkeit der Temperatur aufgetragen. Diese Messung zeigt, daß sich die identifizierten Bereiche der Oberfläche bezüglich der Temperatur (T_{c}), den Restverlusten sowie der Krümmung der Rₛ(T)-Kurven unterscheiden. Es lassen sich daraus schließlich verantwortliche Materialparameter wie Streuraten und Korngrenzeigenschaften isolieren. Das Substrat mit der vermessenen Dünnschicht kann nach der Untersuchung unbeschadet dem quasi-hemisphärischen Fabry-Perot-Resonator entnommen und weiteren Vermessungen oder auch der Fertigung von Komponenten zugeführt werden.

### Bezugszeichenliste

- 1: sphärischer Spiegel
- 2: Koppelloch
- 3: Koppelloch
- 4: ebener Spiegel
- 5: Wafer, Substrat
- 6: Dünnschicht, Probe, Meßobjekt
- 7: inneres Strahlungsschild
- 8: äußeres Strahlungsschild
- 9: Basisplatte
- 10: Basisplatte
- 11: Band, Wärmeleitungsband
- 12: Resonatorachse
- 13: Montageplatte
- 14: Auslegerarm
- 15: Teil
- 16: Platte
- 17: Arm
- 18: Arm
- 19: Strahlungsschildausschnitt
- 20: Strahlungsschildausschnitt
- 21: Berandung
- 22: Stelleinrichtung
- 23: Stelleinrichtung
- 24: Stelleinrichtung
- 25: Heizelement
- 26: Heizelement
- 27: Temperaturfühler
- 28: Temperaturfühler
- 29: Fokusfleck
- 30: Vakuumkessel

## Patentansprüche

1. Quasi-hemisphärischer Fabry-Perot-Resonator zur zerstörungsfreien und berührungslosen sowie temperaturvariablen und ortsaufgelösten Bestimmung des Oberflächenwiderstands Rₛ von elektrisch leitenden Dünnschichtmaterialien, bestehend aus: einem sphärischen, mit hoher Oberflächengüte versehenen Kupferspiegel (1) hoher elektrischer Leitfähigkeit mit zwei nahe beieinander liegenden und in der Nähe der Resonatorachse (12) liegenden Koppellöchern (2, 3) für die Ein (1)- und Auskopplung (3) einer Millimeterwelle in den Resonatorraum (1, 4), einem ebenen, in Strahlrichtung den Resonator begrenzenden Kupferspiegel (4) ebenfalls hoher elektrischer Leitfähigkeit, auf dem ein Wafer (5) mit dem zu untersuchenden Dünnschichtmaterial (6) eingespannt ist,
einer Kühleinrichtung, mit der die beiden Kupferspiegel (1, 4) auf eine vorgegebene Temperatur eingestellt werden können, und einer den gesamten Resonator umgebenden Vakuumkammer,
wobei
die Kühleinrichtung aus zwei gegeneinander wärmeleitungsentkoppelten Strahlungsschilden (7, 8) besteht, die jeweils aus einer gut wärmeleitenden, von Kühlmittel durchströmten Basisplatte (9, 10) bestehen, auf denen je eine Kammer (7, 8) mit verspiegelten metallischen Wänden aufsitzt, wobei sich im ersten, dem eigentlichen Resonatorraum, die beiden Kupferspiegel (1, 4) befinden und der zweite Strahlungsschild (8) den ersten (7) vollständig umgibt,
auf der Basisplatte (9) des inneren Strahlungsschildes (7) der sphärische Kupferspiegel (1), auf den ebene Kupferspiegel (4) ausgerichtet, aufgestellt ist und einen guten Wärmeleitungskontakt zu derselben hat,
der ebene Kupferspiegel (4) an seinem Umfang über ein flexibles, die Wärme gut leitendes Band (11) ausreichender Länge mit der ersten Basisplatte (9) verbunden ist, so daß eine Drehung des Kupferspiegel (4) um die Resonatorachse (12) bis zu 360° durchgeführt werden kann,
der zweite Strahlungsschild (8) wärmeleitungsentkoppelt auf einer Montageplatte (13) steht, auf der ein in Richtung der Resonatorachse (12), seitlich und rotatorisch verstellbarer Auslegerarm (14) seine Basis hat,
der durch die beiden Strahlungsschilde (7, 8) reichende Teil (15) des Auslegerarms (14) aus nicht oder allenfalls schlecht wärmeleitendem Material ist, mit seiner außerhalb der beiden Strahlungsschilde (7, 8) liegenden proximalen Stirnseite an einer abschließenden, gut wärmeleitenden Platte (Wärmewall 16) des Antriebsteils des Auslegerarms (15) verankert und an seiner distalen Stirnseite innerhalb der beiden Strahlungsschilde (7, 8) der ebene Kupferspiegel (4) des Resonators montiert ist,
im Mittelpunkt der beiden Basisplatten (9, 10) je ein Arm (17, 18) drehbar verankert ist, an beiden freien Enden ein Strahlungsschildausschnitt (19, 20) aufragt, die beide ebenfalls von dem Auslegerarm (15) durchdrungen und von ihm bei seitlicher Bewegung mitgenommen werden, so daß beide Strahlungsschilde (7, 8) auch bei seitlicher Auslenkung des Auslegerarms strahlungsmäßig stets geschlossen bleiben,
beide Kupferspiegel (1, 4) des Resonators zum thermischen Trägemachen des kryogenen Teils eine derartige Wärmekapazität haben, daß die thermisch bedingte Verstimmung des Resonators während der Auslesezeit einer Resonanz vernachlässigbar bleibt.

2. Quasi-hemisphärischer Fabry-Perot-Resonator nach Anspruch 1, **dadurch gekennzeichnet, daß**
der ebene Kupferspiegel (4) eine trichterförmige, sich zum sphärischen Resonator hin öffnende, den Resonatorraum nicht störende Berandung (21) hat, die das Wärmeleitungsband (11) bei Drehung des ebenen Kupferspiegels (4) vom Resonatorraum fernhält.

3. Quasi-hemisphärischer Fabry-Perot-Resonator nach Anspruch 2, **dadurch gekennzeichnet, daß**
der die Wände der beiden Strahlungsschilde durchdringende Teil (15) des Auslegerarms und die Distanzstücke (22) zwischen den beiden Basisplatten (9, 10) und der Montageplatte (13) aus Glasfasermaterial sind.

4. Quasi-hemisphärischer Fabry-Perot-Resonator nach Anspruch 3, **dadurch gekennzeichnet, daß**
sich die Stellelemente (22, 23, 24) für den Auslegerarm (14) außerhalb der beiden Strahlungsschilde (7, 8) (Kryobereichs) befinden.

5. Quasi-hemisphärischer Fabry-Perot-Resonator nach Anspruch 4, **dadurch gekennzeichnet, daß**
auf der Basisplatte (9) im Resonatorraum symmetrisch zur Resonatorachse (12) Heizelemente und am ebenen Kupferspiegel (4) mindestens ein Heizelement (25, 26) installiert sind, wobei ein jeweils zugeordneter Temperaturfühler (27, 28) den Wärmeeintrag überwacht.

6. Verfahren zur zerstörungsfreien und berührungslosen sowie temperaturvariablen und ortsaufgelösten Bestimmung des Oberflächenwiderstandes Rₛ von elektrisch leitenden Dünnschichtmaterialien mit einem quasi-hemisphärischen Fabry-Perot-Resonator gemäß Anspruch 1 bis 5,
bestehend aus folgenden Schritten:
i. in den eigentlichen Resonator, der aus einem sphärischen und auf ihn ausgerichteten ebenen Kupferspiegel (1, 4) jeweils hoher Oberflächengüte und guter elektrischer Leitfähigkeit besteht, wird auf den ebenen Kupferspiegel (4) ein Wafer (5) mit dem aufgebrachten Dünnschichtmaterial (6) festgeklemmt und die freie Oberfläche in den Fokusfleck (29) der über den sphärischen Kupferspiegel (1) eingekoppelten Mikrowelle gefahren,
ii. der Resonator wird durch einen ihn umgebenden Verdampferkryostaten, der aus einem inneren, den Resonator unmittelbar umgebenden Strahlungsschild (7) und aus einem denselben völlig umgebenden zweiten Strahlungsschild (8) besteht, in einer einheitlichen kryogenen Umgebung vorgegebener Temperatur gehalten, wobei der äußere Strahlungsschild (8) auf Abgastemperatur gehalten wird,
iii. der ebene Kupferspiegel (4), der am freien Ende eines durch beide Strahlungsschilde (7, 8) reichenden Teils (15) des Auslegerarms (14) keiner oder allenfalls minimaler Wärmeleitfähigkeit fixiert ist, wird über rechnergesteuerte, außerhalb der beiden Strahlungsschilde (7, 8) liegende Stelleinrichtungen (23, 24) an der Basis des Auslegerarms (14) in Position gefahren, wobei der ebene Spiegel (4) bei geöffnetem Kryostaten zunächst über die Stelleinrichtung (25) von Hand auf einen zum sphärischen Kupferspiegel (1) geeigneten Abstand eingestellt wird, bei dem der Gauß sche Grundmode des Resonators optimal fokussiert wird, und die seitliche Verschiebung senkrecht zur Resonatorachse sowie die Drehung bis zu 360° um die Resonatorachse bei geschlossenem Kryostaten und temperiertem Resonator rechnergesteuert durch die motorgetriebenen Antriebseinrichtungen (23, 24) am Auslegerarm (14) durchgeführt wird, wodurch der Fokusfleck (29) der durch die Einkoppelöffnung (2) auf der Resonatorachse (12) des sphärischen Kupferspiegel (1) eingekoppelten und durch denselben fokussierten Mikrowelle auf einen vorgebenen Ort auf der exponierten Dünnschichtoberfläche (6) auftrifft,
iv. die an der Dünnschichtoberfläche (6) lokal erfolgte Mehrfachreflexion der Mikrowelle wird über die unmittelbar neben der Einkoppelöffnung (2) liegende Auskoppelöffnung (3) detektiert und zur Meßwertgewinnung weitergeführt,
v. die Transmission der Mikrowelle durch den Resonator wird als Funktion der Frequenz über ein empfindliches Detektorsystem leistungsmäßig erfaßt und in einem Rechner durch die Methode der kleinsten Fehlerquadrate gemäß einer Lorentzverteilung parametrisiert,
vi. aus dem dadurch gewonnenen Gütewert Q des Resonators wird nach Abtrennung der dem sphärischen Kupferspiegel (1) und den beiden Koppellöchern (2, 3) zuzuordnenden Beiträge der orts- und temperaturabhängige Wert des Oberflächenwiderstandes Rₛ der vermessenen Dünnschicht (6) bestimmt und zur Dokumentierung weiterverarbeitet.

## Claims

1. Quasi-hemispherical Fabry-Perot resonator for the non-destructive and contactless, as well as temperature-variable and locus-resolved, determination of the surface resistance Rₛ of electrically conductive thin-layer materials, comprising:
a spherical copper mirror (1) of high electrical conductivity, which mirror is provided with high surface quality and has two coupling holes (2, 3), which are situated close to each other and lie in the vicinity of the resonator axis (12), for the coupling-in (2) and coupling-out (3) of a millimetre wave in the resonator chamber (1, 4),
a plane copper mirror (4) defining the resonator in the beam direction, which mirror is also of high electrical conductivity and
on which is clamped a wafer (5) provided with the thin-layer material to be investigated,
a cooling arrangement, by means of which the two copper mirrors (1, 4) can be set to a prescribed temperature,
and a vacuum chamber which surrounds the entire resonator,
wherein the cooling arrangement comprises two radiation shields (7, 8), which are decoupled from each other in a heat-conducting manner and each comprise a base plate (9, 10), which plates have good thermal conductivity and are traversed by coolant, a respective chamber (7, 8) resting on each base plate and having vapour-deposited metallic walls, the two copper mirrors (1, 4) being situated in the first, the actual resonator chamber, and the second radiation shield (8) totally surrounding the first radiation shield (7),
the spherical copper mirror (1) is mounted on the base plate (9) of the internal radiation shield (7), in alignment with the plane copper mirror (4), and has a good heat-conducting contact therewith,
the plane copper mirror (4) is connected to the first base plate (9) on its periphery via a flexible strip (11), which conducts the heat well and has an adequate length, so that a rotation of the copper mirror (4) about the resonator axis (12) up to 360° can be accomplished,
the second radiation shield (8) is situated on a mounting plate (13) so as to be decoupled in a heat-conducting manner, and an extension arm (14) has its base on said mounting plate and is laterally and rotatably displaceable in the direction of the resonator axis (12),
the part (15) of the extension arm (14) extending through the two radiation shields (7, 8) is formed from material which is not heat-conductive or is possibly poorly heat-conductive, with its proximal end face situated externally of the two radiation shields (7, 8) being secured on a terminating, good heat-conducting plate (heat barrier 16) of the driving part of the extension arm (15), and the plane copper mirror (4) of the resonator being mounted on its distal end face internally of the two radiation shields (7, 8),
a respective arm (17, 18) is rotatably secured in the centre of the two base plates (9, 10), a radiation shield portion (19, 20) protrudes at both free ends, which portions are both also penetrated by the extension arm (15) and entrained by said arm during lateral displacement, so that both radiation shields (7, 8) always remain closed, in terms of radiation, even with a lateral deflection of the extension arm, and
both copper mirrors (1, 4) of the resonator have such a thermal capacity, for making the cryogenic part thermally inert, that thermally conditional misalignment of the resonator remains negligible during the read-out time of a resonance.

2. Quasi-hemispherical Fabry-Perot resonator according to claim 1, **characterised in that** the plane copper mirror (4) has a funnel-shaped edging (21), which opens towards the spherical resonator and does not disturb the resonator chamber, which boundary keeps the heat-conducting strip (11) remote from the resonator chamber during rotation of the plane copper mirror (4).

3. Quasi-hemispherical Fabry-Perot resonator according to claim 2, **characterised in that** the part (15) of the extension arm, which penetrates the walls of the two radiation shields, and the spacer members (22) between the two base plates (9, 10) and the mounting plate (13) are formed from glass fibre material.

4. Quasi-hemispherical Fabry-Perot resonator according to claim 3, **characterised in that** the control elements (22, 23, 24) for the extension arm (14) are situated externally of the two radiation shields (7, 8) (cryo region).

5. Quasi-hemispherical Fabry-Perot resonator according to claim 4, **characterised in that** heating elements are installed on the base plate (9) in the resonator chamber symmetrically with the resonator axis (12), and at least one heating element (25, 26) is installed on the plane copper mirror (4), a respectively associated temperature gauge (27, 28) monitoring the heat input.

6. Method for the non-destructive and contactless, as well as temperature-variable and locus-resolved determination of the surface resistance Rₛ of electrically conductive thin-layer materials using a quasi-hemispherical Fabry-Perot resonator according to claims 1 to 5,
comprising the following steps:
i. a wafer (5), with the thin-layer material (6) applied thereto, is securedly clamped onto the plane copper mirror (4) into the actual resonator, which comprises a spherical copper mirror (1) and a plane copper mirror (4) aligned therewith, each mirror having a high surface quality and good electrical conductivity, and the free surface is moved into the focussing point (29) of the microwave which is coupled-in via the spherical copper mirror (1),
ii. the resonator is kept in an actual cryogenic environment of a prescribed temperature by means of an evaporator cryostat, which surrounds said resonator and comprises an internal radiation shield (7), which directly surrounds the resonator, and a second radiation shield (8), which totally surrounds said resonator, the external radiation shield (8) being kept at exhaust gas temperature,
iii. the plane copper mirror (4), which is fixed at the free end of a part (15) of the extension arm (14) extending through both radiation shields (7, 8) and having no thermal conductivity or possibly having minimal thermal conductivity, is moved into position at the base of the extension arm (14) via computer-controlled control arrangements (23, 24) which lie externally of the two radiation shields (7, 8), the plane mirror (4) being initially set manually to a suitable spacing from the spherical copper mirror (1), when the cryostat is open via the control arrangement (22, 23 or 24), at which spacing the Gaussian fundamental mode of the resonator is focussed in optimum manner, and the lateral displacement perpendicularly to the resonator axis as well as the rotation up to 360° about the resonator axis, when the cryostat is closed and the resonator is temperature-controlled, are accomplished in a computer-controlled manner by the motor-driven driving arrangements (23, 24) on the extension arm (14), whereby the focussing point (29) of the microwave, which is coupled-in through the coupling-in opening (2) on the resonator axis (12) of the spherical copper mirror (1) and focussed by said mirror, encounters a prescribed locus on the exposed thin-layer surface (6),
iv. the multiple reflection of the microwave, locally produced on the thin-layer surface (6), is detected via the coupling-out opening (3), situated directly adjacent the coupling-in opening (2), and continued to obtain the measurement values,
v. the transmission of the microwave through the resonator is monitored in terms of output as a function of the frequency via a sensitive detector system and parameterised in a computer by the least squares method according to a Lorentz distribution, and
vi. after separation of the contributions to be associated with the spherical copper mirror (1) and the two coupling holes (2, 3), the value of the surface resistance Rₛ of the measured thin layer (6) is determined from the quality factor Q of the resonator thus obtained, said value being dependent on the locus and temperature and being processed further for documentation.

## Revendications

1. Résonateur de FABRY PEROT quasi hémisphérique pour la détermination non destructive et sans contact à température variable et à résolution locale de la résistance de surface (Rₛ) de matières en couche mince conductrice électrique comprenant
- un miroir en cuivre, sphérique, ayant une qualité de surface élevée, une conductivité électrique élevée et deux orifices de couplage (2, 3) rapprochés et à proximité de l'axe (12) du résonateur pour le couplage (1) et le découplage (3) d'une onde millimétrique dans l'enceinte du résonateur (1, 4),
- un miroir en cuivre, plan, délimitant le résonateur dans la direction des rayons, ayant également une conductivité électrique élevée et sur lequel est fixée une plaquette (5) en matière en couche mince (6) à examiner,
- une installation de refroidissement permettant de régler les deux miroirs en cuivre (1, 4) à une température prédéterminée et
- une chambre à vide entourant l'ensemble du résonateur,
dans lequel
l'installation de refroidissement se compose de deux écrans de rayonnement (7, 8) découplés en conduction thermique l'un par rapport à l'autre, ces deux écrans étant chacun formé d'une plaque de base (9, 10) à bonne conduction thermique, traversée par un agent de refroidissement, et sur laquelle repose chaque fois une chambre (7, 8) avec des parois métalliques ayant un poli de la qualité du miroir, et dans la première chambre proprement dite du résonateur se trouvent les deux miroirs en cuivre (1, 4) et le second écran de rayonnement (8) entoure complètement le premier rayonnement (7),
et le miroir en cuivre, sphérique (1), est disposé sur la plaque de base (9) de l'écran de rayonnement intérieur (7) et le miroir en cuivre plan (4) est aligné sur celui-ci, en ayant un bon contact de conduction thermique avec celui-ci,
le miroir en cuivre plan (4) est relié à sa périphérie par un ruban souple (11) bon conducteur de la chaleur, de longueur suffisante le reliant à la première plaque de base (9) pour permettre une rotation du miroir en cuivre (4) autour de l'axe (12) du résonateur sur un angle allant jusqu'à 360°,
le second écran de rayonnement (8) s'appuie sur une plaque de montage (13) en étant découplé du point de vue de la conduction thermique, un bras (14) réglable latéralement et en rotation ayant sa base dans la direction de l'axe (12) du rotor,
la partie (15) du bras (14) qui traverse les deux écrans de rayonnement (7, 8) est en une matière non conductrice de chaleur ou du moins mauvaise conductrice de chaleur, et son côté proximal situé à l'extérieur des deux écrans de rayonnement (7, 8) est ancré à une plaque de fermeture bonne conductrice de chaleur (paroi thermique 16) de la partie (15) d'entraînement du bras et sa face frontale distale porte à l'intérieur des deux écrans de rayonnement (7, 8), le miroir plan (4) du résonateur,
au centre des deux plaques de base (9, 10) est ancré à rotation chaque fois un bras (17, 18) et l'extrémité libre de chaque bras porte une partie de panneau de rayonnement (19, 20) venant en saillie, ce panneau étant entraîné par le bras dans son mouvement latéral pour que les deux écrans de rayonnement (7, 8) restent toujours fermés vis-à-vis des rayonnements même en cas de débattement latéral du bras,
les deux miroirs en cuivre (1, 4) du résonateur, pour assurer l'inertie thermique de la partie cryogénique, ont une capacité calorifique telle que le désaccord d'origine thermique du résonateur pendant le temps de lecture d'une résonance reste négligeable.

2. Résonateur de FABRY PEROT quasi hémisphérique selon la revendication 1,
**caractérisé en ce que**
le miroir en cuivre plan (4) possède un bord (21) en forme de trémie, s'ouvrant en direction du résonateur sphérique et qui ne perturbe pas l'enceinte du résonateur, ce bord écartant le ruban de conduction thermique (11) par rapport à l'enceinte du résonateur lors de la rotation du miroir en cuivre plan (4).

3. Résonateur de FABRY PEROT quasi hémisphérique selon la revendication 2,
**caractérisé en ce que**
les parois de la partie (15) du bras qui traversent les deux écrans de rayonnement et les pièces d'écartement (22) entre les deux plaques de base (9, 10) et la plaque de montage (13) sont en fibres de verre.

4. Résonateur de FABRY PEROT quasi hémisphérique selon la revendication 3,
**caractérisé en ce que**
les éléments de réglage (22, 23, 24) du bras (14) se trouvent en dehors des deux écrans de rayonnement (7, 8) (zones cryogéniques).

5. Résonateur de FABRY PEROT quasi hémisphérique selon la revendication 4,
**caractérisé en ce que**
sur la plaque de base (9), dans l'enceinte du résonateur, symétriquement par rapport à l'axe (12) du résonateur on a des éléments chauffants et sur le miroir en cuivre plan (4) on a au moins un élément chauffant (25, 26) avec chaque fois un capteur de température (27, 28) associé pour surveiller l'apport de chaleur.

6. Procédé de détermination non destructible et sans contact à résolution locale et variable en température de la résistance de surface Rₛ de matière en couche mince conductrice électrique à l'aide d'un résonateur de FABRY PEROT quasi hémisphérique selon les revendications 1 à 5 comprenant les étapes suivantes :
i. dans le résonateur proprement composé d'un miroir en cuivre sphérique et d'un miroir en cuivre plan aligné sur celui-ci (1, 4) ayant chacun une qualité de surface élevée et une bonne conductivité électrique, on fixe sur le miroir en cuivre plan (4), une plaquette (5) portant la matière en couche mince (6) et on conduit la surface libre dans la tache focale (29) de l'onde micrométrique couplée par le miroir sphérique en cuivre (1),
ii. à l'aide d'un cryostat à évaporation qui entoure le résonateur et qui se compose d'un écran de rayonnement, (7) entourant directement le résonateur et d'un second écran de rayonnement (8) entourant complètement l'écran intérieur, on maintient le résonateur à une température prédéterminée, dans un environnement cryogénique uniforme, l'écran de rayonnement extérieur (8) étant maintenu à la température des gaz sortants,
iii. le miroir en cuivre, plan (4) fixé à l'extrémité libre d'une partie (15) du bras (14) traversant les deux écrans de rayonnement (7, 8) et qui ne présente pas de conductivité thermique ou une conductivité dans tous les cas minimale, est conduit en place par des installations de réglage (23, 24) commandées par un calculateur et situées à l'extérieur des deux écrans de rayonnement (7, 8) à la base du bras (14), le miroir plan (4) étant tout d'abord réglé à la main par l'installation de réglage (25), le cryostat étant ouvert, à une distance appropriée par rapport au miroir en cuivre, sphérique (1), position dans laquelle se focalise de manière optimale le mode de base gaussien du résonateur et on effectue le décalage latéral perpendiculairement à l'axe du résonateur ainsi que la rotation jusqu'à 360° autour de l'axe du résonateur lorsque le cryostat est fermé et que le résonateur est mis en température, par une commande par calculateur à l'aide des installations d'entraînement par moteur (23, 24) du bras (14), la tache focale (29) de l'onde micrométrique arrivant par l'orifice de couplage (2) sur l'axe (12) du résonateur du miroir en cuivre, sphérique (1), qui focalise cette onde vers l'endroit prédéterminé à la surface (6) de la couche mince exposée,
iv. on détecte la réflexion multiple de l'onde micrométrique qui se fait localement sur la surface de la couche mince (6) par l'orifice de découplage (3) situé directement à côté de l'orifice de couplage (2) et on transmet le signal pour récupérer la valeur de mesure,
v. on saisit la transmission de l'onde micrométrique par le résonateur comme fonction de la fréquence par un système de détecteur sensible selon la puissance et on paramétrise dans un calculateur selon le procédé de l'erreur quadratique minimale selon la distribution de Lorentz,
vi. à partir de la valeur de qualité Q ainsi obtenue pour le résonateur, après séparation de la participation attribuée au miroir en cuivre sphérique (1) et aux deux orifices de couplage (2, 3) on détermine la valeur de la résistance de surface Rₛ de la couche mince mesurée (6) en fonction du lieu et de la température et on traite l'information.
